Europäisches Patentamt

(19) European Patent Office

Office européen des brevets

(11) Publication number: **0 171 653**
**A2**

## (12) EUROPEAN PATENT APPLICATION

(21) Application number: **85109080.3**

(22) Date of filing: **20.07.85**

(51) Int. Cl.⁴: **G 06 G 7/163**

(30) Priority: **16.08.84 US 641815**

(43) Date of publication of application:
**19.02.86 Bulletin 86/8**

(84) Designated Contracting States:
**DE FR GB NL**

(71) Applicant: **Hewlett-Packard Company**
**Mail Stop 20 B-O 3000 Hanover Street**
**Palo Alto California 94304(US)**

(72) Inventor: **Spaulding, William M., Sr.**
**10607 32nd Drive, S.E.**
**Everett Washington 98204(US)**

(74) Representative: **Schulte, Knud, Dipl.-Ing.**
**c/o Hewlett-Packard GmbH Europ. Patent- und**
**Lizenzabteilung Postfach 1430 Herrenberger Strasse 130**
**D-7030 Böblingen(DE)**

(54) Analog multiplier circuit.

(57) The analog multiplier circuit consists of one or more differential amplifiers (30, 40) coupled to generate first and second currents (5, 6) whose difference varies in response to a first electrical signal (1,2), and each having a summing node for the currents coupled to a signal current source (7, 8, 60) which controls the sums of currents in response to a second electrical signal (3, 4) to make the difference of currents vary in proportion to the product of the signals. Improved accuracy in the multiplication of varying electrical signals is achieved by DC separation between the differential amplifier (30, 40) and the signal current source (7, 8, 60). Bias current for the differential amplifier (30, 40) is provided by a direct current source (17, 18), and the signal current source (7, 8, 60) is AC coupled to the summing node to achieve multiplication of signals. Differential amplifier (30, 40) and signal current source (7, 8, 60) may be emitter coupled transistors (7, 8, 9, 10, 11, 12). AC coupling may be achieved by means of a resistor (15, 16) and a capacitor (13, 14) or by other means.

FIG 1

## ANALOG MULTIPLIER CIRCUIT

### DESCRIPTION

The present invention relates an analog multiplier circuit in accordance with the preamble to claim 1 and 4, respectively. Such circuits may function as mixers in applications where the multiplier is used to multiply two periodic electrical signals of differing frequencies. The product of this multiplication is a signal comprising several sinusoids having the following frequencies: (1) the sum of the input frequencies; (2) the difference between the input frequencies; (3) the input frequencies individually; and (4) spurious frequencies. Typically, the objective of this frequency multiplication process is to effect a frequency translation of an input signal.

Circuits according to the respective claim preambles are known in the art, see, e.g., the book "Analoge integrierte Schaltungen" by Miklos Herpy, Franzis-Verlag, Munich, 1979, pp. 446-493. It is known in the art that the DC offset voltages and currents of the differential amplifier respectively amplifiers used in such circuits produce inaccuracies, or errors, in multiplication (Herpy, p. 464-473). In broadband mixer applications these inaccuracies produce undesired spurious frequencies that cannot be filtered out or otherwise compensated for at the mixer output. It is also known in the art that the adjustment of such circuits is a rather involved procedure wherein the results achieved are generally less than perfect because of the nature of the circuit (Herpy, p.473-477).

Relative to this the present invention solves the problem of devising circuits in accordance with the preambles to claim 1 and claim 4, respectively, wherein improved accuracy in the multiplication of varying electrical signals is achievable.

The solution of this problem, as claimed in claim 1, relies on a recognition of the fact that the signal current source which in the known circuit receives and controls the current flowing through the summing node of the differential amplifier, may in the multiplication of varying electrical signals be DC separated from the summing node, although at a first sight such DC separation would seem to impair the operation of the differential amplifier. This applies equally well to circuits having more than one differential amplifier and signal current source, such as claimed in claim 4.

DC separation without upsetting operation of the differential amplifier is achieved by connecting a direct current source to the summing node for delivering thereto the DC bias current which is needed for the differential amplifier to operate. Control by the signal current source of the current flowing through the summing node, to effect multiplication of the varying electrical signals, is achieved by AC coupling the signal current source to the summing node so that the signal current is superimposed onto the DC bias current.

With DC separation as claimed in claims 1 and 4 the circuit may be adjusted to minimize offset voltage and current errors without the adjustment of the differential amplifier affecting the adjustment of the signal current source, and vice versa. Interdependence between adjustment parameters is avoided which allows for significantly improved ease and accuracy of adjustment and thus, improvement of accuracy in multiplication.

The claims depending from claims 1 and 4, respectively, are directed to preferred embodiments of the invention which provide for simple design of actual circuits.

In the preferred embodiment according to claims 2 and 5, respectively, the AC coupling means comprise a capacitor-resistor combination. Any DC isolation means that also functions as an AC short, however, such as a transformer or optical coupler, could also be used for AC coupling.

In mixer applications the differential amplifier may be operated to function as a differential switch; Of the two input signals, one (frequency $f_1$) is applied to the signal current source or sources while the other (frequency $f_2$) drives the differential switch. Thus multiplication of the two signals is effected by switching the polarity of the linear signal $f_1$ at a rate $f_2$. The output consists of the frequency products of the multiplication process.

An embodiment of the invention will now be described in detail with reference to the accompanying drawing.

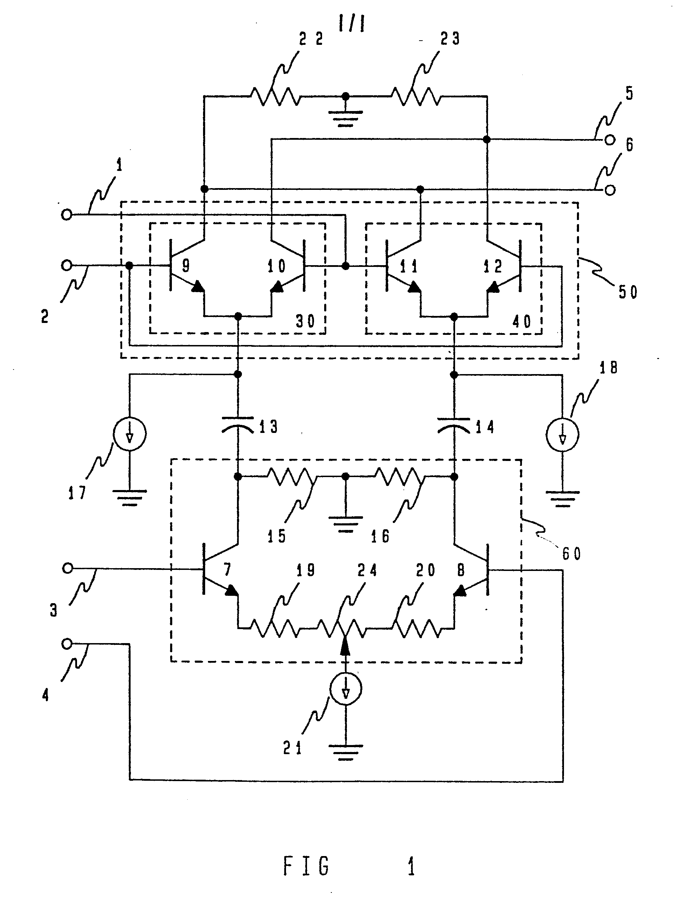

Figure 1 shows a doubly balanced active mixer circuit with capacitive coupling between stages of the multiplying elements.

In the circuit shown in Figure 1 there are six transistors that are configured into three pairs. Each pair forms a differential amplifier with two emitter-coupled NPN transistors. Thus, transistors 9 and 10 together form differential amplifier 30, transistors 11 and 12 together form differential amplifier 40, and transistors 7 and 8 together form a third differential amplifier 60. Differential amplifier 60 is functionally used as a linear amplifer. Differential amplifiers 30 and 40 are functionally used as differential switches and together form mixer cell 50. Additionally, both differential switches 30 and 40 are connected to biasing resistors 22 and 23, while reasonably constant matched current sources 17 and 18 are connected to differential switch 30 and to differential switch 40 respectively.

The first input signal (for example, a square wave) is differentially input to both differential switch 30 and to differential switch 40 via differential inputs 1 and 2. When the signal amplitude on differential input 1 is greater than the signal ampitude on differential input 2, transistors 10 and 11 are turned on, and transistors 9 and 12 are turned off. During this condition, the amplified second input signal passes from the collectors of transistors 7 and 8 through transistors 10 and 11 respectively and is then differentially output on lines 5 and 6 respectively. In particular, the signal on line 3 passes to output line 5 while the signal on line 4 passes to output line 6.

Alternatively, when the signal amplitude on differential input 1 is less than the signal amplitude on differential input 2, transistors 10 and 11 are turned off and transistors 9 and 12 are turned on. Under this condition, the signal from the collectors of transistors 7 and 8 passes through transistors 9 and 12 respetively and is then differentially output on lines 6 and 5 respectively. In particular, the signal on line 3 passes to output line 6 while the signal on line 4 passes to output line 5.

The second input signal (for example, a sinusoid) is differentially input to linear amplifier 60 via differential inputs 3 and 4. After amplification, the signals from linear amplifier transistors 7 and 8 pass to differential switches 30 and 40. Transistors 7 and 8 also have biasing resistors 15 and 16 respectively, and emitter degeneration resistors 19 and 20 respectively; the latter resistor pair is used for the purpose of increasing the input voltage range over which linear operation is possible. Potentiometer 24 is adjusted for the purpose of balancing linear amplifier 60. The current source 21 maintains reasonably constant emitter current in transistors 7 and 8.

Capacitors 13 and 14 provide both AC coupling and DC isolation between differential switches 30 and 40, and linear amplifier 60 so that DC bias level variations in linear amplifier 60 do not affect the DC balance of differential switches 30 and 40. Capacitor 13 functions as an AC short from the collector of transistor 7 to the emitters of transistors 9 and 10. Capacitor 13 also functions as a DC open for the same path in which it is an AC short. Similarly, capacitor 14 functions as both an AC short and DC open between the collector of transistor 8 and the emitters of transistors 11 and 12.

The purpose of this capacitive coupling is to provide DC isolation of differential switches 30 and 40 from linear amplifier 60 and consequently to suppress the generation of spurious frequencies (spurs). This DC isolation suppresses spurs by preventing unbalanced emitter bias levels from developing in the differential switch transistors as a result of unequal DC bias levels on the collectors of transistors 7 and 8. The unequal collector bias levels may arise in transistors 7 and 8 as a consequence of the matching of these transistors and the balancing of the bias network for optimum AC differential balance (minimal difference mode distortion). Thus, the DC isolation created by capacitive coupling permits the balancing of the differential switch transistor pairs to be performed independently from the linear amplifier balancing process. Consequently, spurs that are generated during the multiplication process may be reduced in amplitude by as much as 10 dB from those produced without AC coupling of the present invention.

## ANALOG MULTIPLIER CIRCUIT

### CLAIMS

1. An analog multiplier circuit comprising
   - a differential amplifier for producing a first and a second current flowing through a summing node thereof, the difference between the first and the second current varying in response to a first electrical input signal; and
   - a signal current source coupled to be responsive to a second electrical input signal for controlling the current flowing through the summing node; wherein
   - the difference between the first and the second current varies substantially in proportion to the product of the first and the second electrical input signal;

   c h a r a c t e r i z e d   in that, for improving accuracy in the multiplication of varying electrical signals, there is provided
   - a direct current source (17) connected to the summing node for delivering a direct current thereto; and
   - AC coupling means (13, 15) for AC coupling the signal current source to the summing node.

2. A circuit as in claim 1, characterized in that the AC coupling means comprises a resistor (15) connected to convert the current of the signal current source (7) into a signal voltage and a capacitor (13) connected to couple a signal current to the summing node in response to the signal voltage.

3. A circuit as in claim 1 or 2, characterized in that
   - the differential amplifier (30) comprises a first transistor (9) and a second transistor (10) and
   - the summing node is a connection of the emitter of the first transistor (9) to the emitter of the second transistor (10).

4. An analog multiplier circuit comprising
   - a first differential amplifier for producing a first and a second current flowing through a summing node thereof, the difference between the first and the second current varying in response to a first electrical input signal;

- a second differential amplifier for producing a third and a fourth current flowing through a summing node thereof, the difference between the third and the fourth current varying in response to the inverse of the first electrical input signal;

- a first signal current source coupled to be responsive to a second electrical input signal for controlling the current flowing through the summing node of the first differential amplifier; and

- a second signal current source coupled to be responsive to the inverse of the second electrical input signal for controlling the current flowing through the summing node of the second differential amplifier; wherein

- the difference between the sum of the first and the third current and the sum of the second and the fourth current varies substantially in proportion to the product of the first and the second electrical input signal;

c h a r a c t e r i z e d  in that, for improving accuracy in the multiplication of varying electrical signals, there is provided

- a first direct current source (17) connected to the summing node of the first differential amplifier (30) for delivering a first direct current thereto;

- a second direct current source (18) coupled to the summing node of the second differential amplifier (40) for delivering a second direct current thereto;

- first AC coupling means (13, 15) for AC coupling the first signal current source (7) to the summing node of the first differential amplifier (30); and

- second AC coupling means (14, 16) for AC coupling the second signal current source (8) to the summing node of the second differential amplifier (40).

5. A circuit as in claim 4, characterized in that
- the first AC coupling means (13, 15) comprises a first resistor (15) connected to convert the current of the first signal current source (7) into a first signal voltage, and a first capacitor (13) connected to couple a first signal current to the summing node of the first differential amplifier (30) in response to the first signal voltage; and

- the second AC coupling means (14, 16) comprises a second resistor (16) connected to convert the current of the second signal current source (8) into a second signal voltage, and a second capacitor (14) connected to couple a second signal current to the summing node of the second differential amplifier (40) in response to the second signal voltage.

6. A circuit as in claim 4 or 5, characterized in that
- the first signal current source is a first current output port of a third differential amplifier (60); and
- the second signal current source is a second current output port of the third differential amplifier (60).

7. A circuit as in one of claims 4 through 6, characterized in that
- the first differential amplifier (30) and the second differential amplifier (40) each comprise a first transistor (9, 11) and a second transistor (10, 12); and
- each summing node is a connection of the emitter of the respective first transistor (9,11) to the emitter of the respective second transistor (10, 12).

1/1

FIG 1